(19) Europäisches Patentamt
European Patent Office
Office européen des brevets

(11) **EP 3 285 380 B1**

(12) **EUROPEAN PATENT SPECIFICATION**

(45) Date of publication and mention
of the grant of the patent:
**06.11.2019 Bulletin 2019/45**

(51) Int Cl.:
***H02M 1/092*** *(2006.01)*      ***H02M 1/34*** *(2007.01)*

(21) Application number: **16184528.4**

(22) Date of filing: **17.08.2016**

(54) **VOLTAGE BALANCING OF VOLTAGE SOURCE CONVERTERS**

SPANNUNGSAUSGLEICH VON SPANNUNGSQUELLENWANDLERS

ÉQUILIBRAGE DE TENSION POUR DES CONVERTISSEURS DE SOURCE DE TENSION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**21.02.2018 Bulletin 2018/08**

(73) Proprietor: **General Electric Technology GmbH 5400 Baden (CH)**

(72) Inventors:
- **CHIVITE-ZABALZA, Francisco Javier Stafford, Staffordshire ST17 4XQ (GB)**
- **TRAINER, David Reginald Derby, Derbyshire DE24 0AQ (GB)**
- **OUTRAM, John Lewis Stone, Staffordshire ST15 8YD (GB)**
- **OATES, Colin Donald Murray Stafford, Staffordshire ST17 0TL (GB)**
- **DAVIDSON, Colin Charnock Stafford, Staffordshire ST15 4PS (GB)**

(74) Representative: **Freigutpartners IP Law Firm Hahnrainweg 4 5400 Baden (CH)**

(56) References cited:
EP-A1- 0 868 014     EP-A1- 2 961 057
WO-A1-02/23704     WO-A1-2016/026913
US-A1- 2010 265 740     US-A1- 2013 082 762

**Description**

This application relates to a voltage source converter and to methods and apparatus for control of a director switch of a voltage source converter for voltage balancing, and especially to a voltage source converter for use in high voltage power distribution and in particular to a voltage source converter having converter arms with a director switch having multiple switching elements each having an associated clamp capacitor.

The prior art US 2013/0082762 A1 discloses a voltage balance module of a power switch series circuit. A voltage balance module may include a clamping circuit which may function to clamp the voltage between the second terminal and the third terminal of the power switch to a threshold voltage.

US 2010/026 557 40 A1 discloses a power conversion system including a switch circuit. A supply circuit forms part of the switch circuit which includes a supply storage device 135.

HVDC (high-voltage direct current) electrical power transmission uses direct current for the transmission of electrical power. This is an alternative to alternating current electrical power transmission which is more common. There are a number of benefits to using HVDC electrical power transmission.

In order to use HVDC electrical power transmission, it is typically necessary to convert alternating current (AC) to direct current (DC) and back again. To date most HVDC transmission systems have been based on line commutated converters (LCCs), for example such as a six-pulse bridge converter using thyristor valves. LCCs use elements such as thyristors that can be turned on by appropriate trigger signals and remain conducting as long as they are forward biased and current remains flowing. In LCCs the converter relies on the connected AC voltage to provide commutation from one valve to another.

Increasingly however voltage source converters (VSCs) are being proposed for use in HVDC transmission. HVDCs use switching elements such as insulated-gate bipolar transistors (IGBTs) that can be controllably turned on and turned off independently of any connected AC system. VSCs are thus sometimes referred to as self-commutating converters.

VSCs typically comprise multiple converter arms, each of which connects one DC terminal to one AC terminal. For a typical three phase AC input/output there are six converter arms, with the two arms connecting a given AC terminal to the high and low DC terminals respectively forming a phase limb. Each converter arm comprises an apparatus which is commonly termed a valve and which typically comprises a plurality of elements which may be switched in a desired sequence.

In one form of known VSC, often referred to as a six switch converter, each valve comprises a set of series connected switching elements, typically insulated gate bipolar transistors (IGBTs) connected with respective antiparallel diodes. The IGBTs of the valve are switched together to electrically connect or disconnect the relevant AC and DC terminals, with the valves of a given phase limb typically being switched in antiphase. By using a pulse width modulated (PWM) type switching scheme for each arm, conversion between AC and DC voltage can be achieved.

In another known type of VSC, referred to a modular multilevel converter (MMC), each valve comprises a chain-link circuit having a plurality of cells connected in series, each cell comprising an energy storage element such as a capacitor and a switch arrangement that can be controlled so as to either connect the energy storage element between the terminals of the cell or bypass the energy storage element. The cells are sometimes referred to as sub-modules, with a plurality of cells forming a module. The sub-modules of a valve are controlled to connect or bypass their respective energy storage elements at different times so as to vary over the time the voltage difference across the plurality of cells. By using a relatively large number of sub-modules and timing the switching appropriately the valve can synthesise a stepped waveform that approximates to a desired waveform, such as a sine wave, to convert from DC to AC or vice versa with low levels of harmonic distortion. As the various sub-modules are switched individually and the changes in voltage from switching an individual sub-module are relatively small a number of the problems associated with the six switch converter are avoided.

In the MMC design each valve is operated continually through the AC cycle with the two valves of a phase limb being switched in synchronism to provide the desired voltage waveform.

Recently a variant converter has been proposed wherein a chain-link of a series of connected cells is provided in a converter arm for providing a stepped voltage waveform as described, but each converter arm is turned off for at least part of the AC cycle. Thus the plurality of series connected cells for voltage wave-shaping are connected in series with an arm switch, referred to as a director switch, which can be turned off when the relevant converter arm is in the off state and not conducting. Such a converter has been referred to as an Alternate-Arm-Converter (AAC). An example of such a converter is described in WO2010/149200.

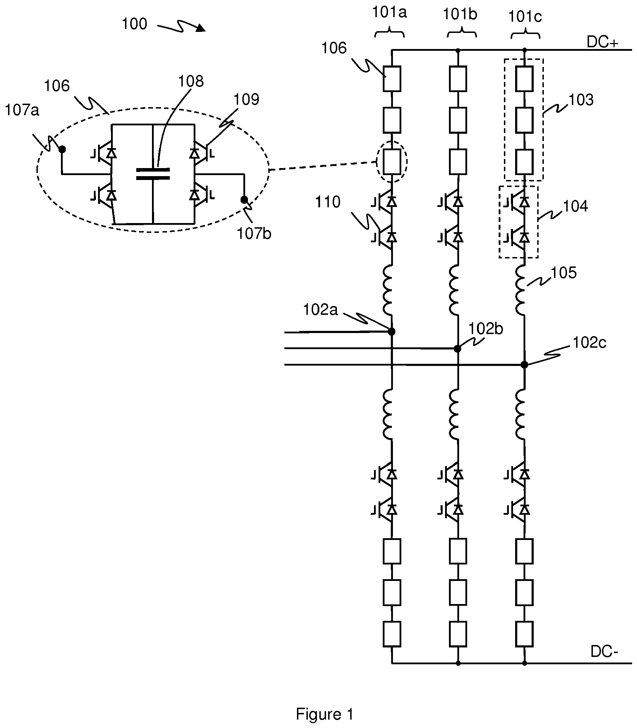

Figure 1 illustrates a known Alternate-Arm-Converter (AAC) 100. The example converter 100 has three phase limbs 101a-c, each phase limb having a high side converter arm connecting the relevant AC terminal 102a-c to the high side DC terminal DC+ and a low side converter arm connecting the relevant AC terminal 102a-c to the low side DC terminal DC-. Each converter arm comprises a circuit arrangement 103 of series connected cells, the arrangement 103 being in series with an arm switch 104 and inductances 105. It will be noted that figure 1 illustrates a single arm inductance but one skilled in the art will appreciated that the arm inductance may in practice be distributed along the arm between the AC and DC terminals.

The circuit arrangement 103 comprises a plurality of cells 106 connected in series. Each cell 106 has an energy storage element that can be selectively connected in series between the terminals of the cell or bypassed. In the example shown in figure 1 each cell 106 has terminals 107a, 107b for high-side and low-side connections respectively and comprises a capacitor 108 as an energy storage element. The capacitor 108 is connected with cell switching elements 109, e.g. IGBTs with antiparallel diodes, to allow the terminals 107a and 107b of the cell to be connected via a path that bypasses capacitor 108 or via a path that includes capacitor 108 connected in series. In the example illustrated in figure 1 each cell comprises four cell switching elements 109 in a full H-bridge arrangement such that the capacitor can be connected in use to provide either a positive or a negative voltage difference between the terminals 107a and 107b. In some embodiments however at least some of the cells may comprise switching elements in a half bridge arrangement such that the capacitor can be bypassed or connected to provide a voltage difference of a given polarity. The circuit arrangement 103 of such series connected cells can thus operate to provide a voltage level that can be varied over time to provide stepped voltage waveform for wave-shaping as discussed above. The circuit arrangement 103 is sometimes referred to as a chain-link circuit or chain-link converter or simply as a chain-link. In this disclosure the circuit arrangement 103 of such series connected cells for providing a controlled voltage shall be referred to as a chain-link.

In the AAC converter the chain-link 103 in each converter arm is connected in series with an arm switch 104, which will be referred to herein as a director switch, which may comprise a plurality of series connected arm switching elements 110. The director switch of a converter arm may for example comprise high voltage elements with turn-off capability such as IGBTs or the like with antiparallel diodes. When a particular converter arm is conducting, the chain-link 103 is switched in sequence to provide a desired waveform in a similar fashion as described above with respect to the MMC type converter. However in the AAC converter each of the converter arms of a phase limb is switched off for part of the AC cycle and during such a period the director switch 104 is turned off.

When the converter arm is thus in an off state and not conducting the voltage across the arm is shared between the director switch and the chain-link circuit. Compared to the MMC type VSC the required voltage range for the chain-link of each converter arm of an AAC type converter is thus reduced, with consequent savings in the cost and size of the converter.

As mentioned above the director switch 104 is typically formed from a plurality of series connected IGBTs. The IGBTs are typically connected in parallel with a balancing resistor for static voltage sharing between the individual switching elements of the director switch. In addition there may be a clamp snubber circuit located next to the IGBT to mitigate voltage overshoot during a turn-off transient event which comprises a capacitor and diode.

One issue that can arise in such an arrangement is a voltage imbalance across the switch elements of the director switch, e.g. the IGBTs and the associated clamp capacitors. The present disclosure thus relates to methods and apparatus for control of voltage source converters that address issues of voltage imbalance.

Thus according to the present invention there is provided a method in accordance with claim 1 of controlling a director switch unit of a voltage source converter comprising a semiconductor switching element and an associated clamp capacitor connected across the semiconductor switching element, the method comprising, in a voltage balancing mode: operating the director switch unit in a voltage balancing mode such that power drawn from the clamp capacitor varies based on the voltage across the clamp capacitor. The method comprises, in the voltage balancing mode, varying the power demand or the current demand of a power supply that draws power from the clamp capacitor based on the voltage of the clamp capacitor.

By operating in a voltage balancing mode such that the power drawn from the clamp capacitor varies with the voltage of the clamp capacitor, rather than having a constant power characteristic, voltage balancing of the clamp capacitors of multiple serially connected director switch units can be achieved. In the voltage balancing mode the power demand for power drawn from the clamp capacitor may have the characteristic of a resistive load. Thus a greater current may be drawn as the voltage of the clamp capacitor increases ensuring that the clamp capacitors with the greatest voltages are discharged more than those with lower voltages.

In some examples the method involves, in the voltage balancing mode, varying the power demand of a power supply that draws power from the clamp capacitor, for instance a floating power supply, based on the voltage of the clamp capacitor. The voltage of the clamp capacitor may be compared to at least one voltage threshold. A power demand may be determined based on said comparison. In some examples the power demand may have a first value if the clamp capacitor voltage is below a first threshold and a second, higher, value if the clamp capacitor voltage is above the first threshold. In some examples the method involves, in the voltage balancing mode, varying the current demand from the clamp capacitor based on the voltage of the clamp capacitor. In some examples the current demand may have a component proportional to the voltage of the clamp capacitor. The current demand may include a component which is inversely proportional to a virtual resistance value. The virtual resistance value may be selected to give a predetermined rated power at a maximum expected clamp capacitor voltage. In some examples the current demand may further have a component that varies based on an indication of the rate of change of the clamp capacitor voltage. The current demand may be controlled by controlling a controllable current source.

In some examples the method involves, in the voltage balancing mode, varying, controlling a crowbar circuit connected in parallel with the clamp capacitor so as to provide a predetermined average resistance value, wherein the crowbar circuit comprises a crowbar resistor in series with a semiconductor switching element. The semiconductor switching element of the crowbar circuit may be controlled in a duty cycle to provide the predetermined average resistance value.

Any additional power drawn which is in excess of the rated power demand of a power supply of the director switch unit may be stored in an energy storage reservoir of the power supply. In some instances the power supply may further comprise a balancing reservoir for storing power drawn in the voltage balancing mode. The method may comprise monitoring the voltage of the balancing reservoir and discharging the balancing reservoir when above a predetermined voltage level.

In some examples the director switch unit may comprise at least one loading resistor, the loading resistor having a resistance value such that, in use at a clamp capacitor voltage within the nominal operating range of the director switch unit, the current drawn from the clamp capacitor increases with clamp capacitor voltage. The at least one loading resistor may comprise a loading resistor in parallel with a snubber diode and/or a loading resistor in parallel with the clamp capacitor.

Also provided is a director switch unit in accordance with claim 14 of a voltage source converter comprising: a semiconductor switching element; and a clamp capacitor connected across the semiconductor switching element, the director switch unit being operable in a voltage balancing mode such that the power drawn from the clamp capacitor varies based on the voltage across the clamp capacitor. The director switch unit is in a voltage balancing mode, controllable to varying the power demand or the current demand of a power supply that draws power from the clamp capacitor based on the voltage of the clamp capacitor.

Any of the variants of the method described above may be applicable to the director switch unit. In particular, in the voltage balancing mode, the director switch unit is configured such that the power demand for power drawn from the clamp capacitor has the characteristic of a resistive load.

The director switch unit may comprise a power supply, such as a floating power supply, that draws power from the clamp capacitor and a controller for controlling the power drawn from the clamp capacitor.

In some examples the controller may be configured to, in the voltage balancing mode, vary the power demand of the power supply based on the voltage of the clamp capacitor. The controller may be configured to compare the clamp capacitor voltage to at least one voltage threshold and determine a power demand based on said comparison. The controller may control the power demand to a first value if the clamp capacitor voltage is below a first threshold and to a second, higher, value if the clamp capacitor voltage is above the first threshold.

In some examples the controller may be configured to, in the voltage balancing mode, vary the current demand from the clamp capacitor based on the voltage of the clamp capacitor. The controller may be configured to control the current demand to have a component proportional to the voltage of the clamp capacitor. The current demand may have a component inversely proportional to a virtual resistance value. The virtual resistance value may be selected to give a predetermined rated power at a maximum expected clamp capacitor voltage. The current demand may further have a component that varies based on an indication of the rate of change of the clamp capacitor voltage. The director switch unit may include a controllable current source. The controller may be configured to vary the current demand by controlling the controllable current source.

In some examples the director switch unit comprises a crowbar circuit connected in parallel with the clamp capacitor and a controller for controlling the crowbar circuit so as to provide a predetermined average resistance value, wherein the crowbar circuit comprises a crowbar resistor in series with a semiconductor switching element. The controller may be configured to control the semiconductor switching element of the crowbar circuit in a duty cycle to provide the predetermined average resistance value.

The power supply may comprise an energy storage reservoir and the director switch unit may be configured such that any additional power drawn which is in excess of the rated power demand of the power supply of the director switch unit is stored in the energy storage reservoir. The power supply may further comprise a balancing reservoir for storing power drawn in the voltage balancing mode. A monitor may be provided for monitoring the voltage of the balancing reservoir and discharging the balancing reservoir when above a predetermined voltage level.

In some examples the director switch unit may comprise at least one loading resistor, the loading resistor having a resistance value such that, in use at a clamp capacitor voltage within the nominal operating range of the director switch unit, the current drawn from the clamp capacitor increases with clamp capacitor voltage. The at least one loading resistor may comprise a loading resistor in parallel with a snubber diode. The at least one loading resistor may comprise a loading resistor connected across or in parallel with the clamp capacitor.

The invention will now be described by way of example only with respect to the accompanying drawings, of which:

Figure 1 illustrates one example of an alternate-arm-converter (AAC) type voltage source converter (VSC);

Figure 2 illustrates one example of circuitry associated with a switching element of a director switch of a VSC;

Figure 3 illustrates simulated results for a director switch operating with an initial voltage imbalance;

Figure 4 illustrates the principles of varying the rate power of the floating power supply based on the clamp capacitor voltage;

Figure 5 illustrates simulated results for a director switch operating according to strategy discussed with respect figure 4;

Figure 6 illustrates control over charging of the long term storage based on the change in clamp capacitor voltage;

Figure 7 illustrates simulated results for a director switch operating according to another embodiment;

Figure 8 illustrates PWM control of the crowbar circuit;

Figure 9 illustrates simulated results for a director switch operating according to strategy discussed with respect to figure 8;

Figure 10 illustrates a director switch unit with an additional balancing reservoir;

Figure 11 illustrates a converter arm according to an embodiment;

Figure 12 illustrates current based control of the DC/DC converter of the floating power supply; and

Figures 13a and 13b illustrates another example using loading resistors.

As mentioned above some types of voltage source converter (VSC), such as the alternate-arm-converter (AAC) illustrated in figure 1, comprise an arm switch 104 in a converter arm of the VSC for switching the converter arm between being conductive or non-conductive during the power cycle. Such an arm switch is referred to herein as a director switch. To provide the necessary voltage rating the director switch will typically comprise a plurality of switching elements 110 such as IGBTs connected in series.

In use the director switch of a converter arm may be turned off for part of the power cycle. In the AAC type converter, where each converter arm comprises a director switch 104 in series with a chain-link circuit 103 for voltage wave-shaping, the director switch of a converter arm is turned off at a desired point in the power cycle. In normal operation the director switch is turned off (or on) at a point when the chain-links of the converter arms of the phase limb are providing suitable voltages such that the voltage across the director switch being turned off (or on) is substantially zero. The two converter arms of a phase limb are also controlled together so that in normal operation there is substantially no current through the director switch at the point at which it is turned-off or on.

Once turned off the voltage across the director switch typically increases as the voltage at the AC terminal of the phase limb varies. To ensure correct voltage sharing between the various switching elements of the director switch there is typically a balancing resistor connected in parallel with each switch element. Additionally there is typically a clamp snubber circuit comprising at least a capacitor and a diode to mitigate voltage overshoot during a turn-off transient event.

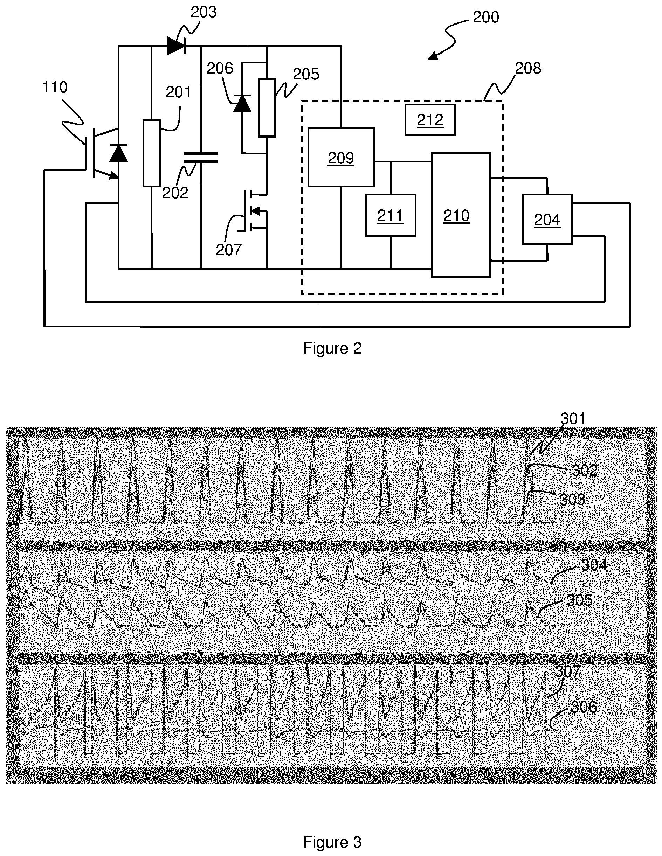

Figure 2 illustrates one example of a director switch unit 200 associated with an individual switching element 110 of a director switch. As used herein the term director switch unit shall be used to refer to an individual switching element 110 and its associated circuitry. The switching element 110 comprises a semiconductor switching element such as an IGBT with antiparallel diode. In parallel with the IGBT 110 is typically a balancing resistor 201. A clamp snubber circuit comprises clamp capacitor 202 connected in parallel with the IGBT 110 via snubber diode 203. In some instances a resistor (not shown) may be connected across the snubber diode 203 to provide for slow or long-term discharge of the capacitor voltage for safe handling, after power off. The IGBT 110 is controlled by local control electronics 204 including a suitable gate driver. There may also be a crowbar circuit in parallel with the switching element 110, the crowbar comprising a parallel combination of resistor 205 and diode 206 in series with a semiconductor switch element such as transistor 207.

It will be appreciated that figure 2 only illustrates those components that are of interest for the present disclosure and in practice there may be may additional components and circuitry associated with the individual switching elements of the director switch such as crowbar circuits or surge arrestors for example.

Recently it has been proposed that the local control electronics may be powered by a floating power supply 208 that draws power from the capacitor 202 that forms part of the clamp snubber circuit. In the example illustrated in figure 2 the floating power supply 208 thus comprises a first DC-DC converter 209 for converting from the high voltage across the IGBT/clamp capacitor 202 to an intermediate voltage and a second DC-DC converter 210 for converting to a low voltage suitable for powering the control electronics 204, e.g. gate driver, for the IGBT 110. The floating power supply may also comprise some long term energy storage 211 such as a suitable capacitor arrangement for providing power during fault events where there may temporarily be no voltage across the director switch.

The floating power supply 208 typically exhibits a constant power load characteristic, due to the control loop of the DC-DC converters 209 and 210 which keep the output voltage constant regardless of any variation in input voltage. Therefore, if the load current demanded by the gate driver of the control electronics 204 remains constant, as it is typically the case, the input current demanded by the floating power supply 208 will change to keep a constant product of voltage V and current I, i.e. a constant V*I product. Thus if the input voltage to the floating power supply, i.e. the voltage across the clamp capacitor 202, increases or decreases, the input current will proportionally decrease or increase respectively.

It has been appreciated that this effect can contribute to any imbalance in voltage across the IGBTs and corresponding clamp capacitors of the director switch units of the director switch. If the voltage across a given IGBT 110 or its associated clamp capacitor 202 decreases then a greater current will be demanded by the floating power supply, which will contribute to a further voltage decrease. Conversely if the voltage across the IGBT/clamp capacitor is increasing then the input current demanded by the floating power supply will decrease, thus contributing to a further increase in the voltage across the IGBT/clamp capacitor.

Due to the relatively small capacitance of the clamp capacitor 202, which may for instance be of the order of 1 $\mu$F, this effect may be significant. It has been found that for a director switch formed from director switch units which include a floating power supply arranged to take power from the clamp capacitor, then any component mismatch between the director switch units, e.g. between the voltage balancing resistors associated with different IGBTs, or any difference in the instantaneous voltage across the director switch units can lead to a relatively large voltage imbalance being generated over a number of cycles of VSC operation.

This is especially the case if the floating supply is 208 charging the long term storage 211, when the power drawn by the floating supply is comparatively greater than that drawn during normal operation.

Figure 3 illustrates waveforms for a simulated director switch having a voltage imbalance between the switching elements. The director switch was simulated with just first and second director switching units, with the first switching unit having a higher starting instantaneous voltage than the second switching unit, and the simulation covered several power cycles of the converter arm. The starting voltage of the clamp capacitor of the first switching unit was simulated at 1500V with the capacitor of the second switching unit at 500V. The floating power supply was simulated with a power draw of 22W.

The top plot of figure 3 illustrates the voltage waveform 301 across the whole director switch and the voltage waveforms 302 and 303 across the switching elements of the first and second switching units respectively. The middle plot shows the voltages 304 and 305 of the clamp capacitors of the first and second switching units respectively. The lower plot illustrates the current demand 306 of the floating power supply of the first switching unit and the current demand 307 of the floating power supply of the second switching unit.

It can be seen that the initial starting voltage difference quickly leads to an increasing voltage imbalance and the system quickly diverges to a situation of a high voltage imbalance. Also, the floating power supply of the first director switch unit, corresponding to the clamp capacitor with the highest voltage, takes less current than that of the second director switch unit with a lower voltage across it.

In the simulation results illustrated in figure 2 the current demand in the floating supply corresponding to the clamp capacitor with less voltage across is repeatedly interrupted during a substantial part of the cycle. In this example the DC-DC converter stops operation if the input voltage drops below a threshold value, for instance to prevent the input current becoming too high at low input voltages or due to other deign considerations.

The effect of the floating power supply can thus be seen to exacerbate any initial voltage difference. This could finally result that an excess voltage is developed across some director switch units whilst there is a loss of power for the control electronics of others.

It will be well understood by one skilled in the art that the voltage of a clamp capacitor reaching high levels is potentially dangerous as it can cause the destruction of devices and circuit components. The director switching unit thus typically includes one or more protective measures such as the crowbar circuit. In the event of an over-voltage the transistor 207 of the crowbar circuit may be turned on to discharge the clamp capacitor via crowbar resistor 205. There may additionally or alternatively be a surge protection device (not shown in figure 2) in parallel with the switching element 110. In some VSCs there may be an active clamping circuit built in the gate driver of each IGBT.

There may be thus some mechanism for coping with over-voltage of a clamp capacitor, however were a clamp capacitor voltage to fall below the operating threshold of the floating supply, this would cause the main DC-DC converter 209 to stop working. If during that time there is not enough energy stored in the long-term storage 211 to repeatedly maintain the operation of the gate driver supply, some IGBTs will be unexpectedly turned off, with a consequent risk of destruction. Since this imbalance situation may well arise when the long-term storage stage is being charged, it is very likely that the long-term storage capacitors will not have enough energy accumulated to support this situation.

Embodiments of the present invention thus relate to methods and apparatus for voltage balancing that at least mitigate some of the above mentioned issues and which can be used satisfactorily with switching units having a floating power supply that draws power from the clamp capacitor. As will be described in more detail below embodiments of the present invention may operate such that the load on the clamp capacitor, which comprises the floating power supply, behaves as a resistive load.

In a method according an embodiment of the present invention the director switching unit of a director switch is controlled such that the power drawn from the clamp capacitor, at least in a voltage balancing mode, varies based on the voltage across the clamp capacitor. The director switch may be operated such the power demand for power drawn from the clamp capacitor has the characteristic of a resistive load, rather than a constant power load.

As will be understood by one skilled in the art the properties of a resistive load are such that if the voltage across the load is increased, the current drawn by the load is also increased. In such a case were there to be a voltage imbalance between two clamp capacitors of two director switching units then a greater current would be drawn from the clamp capacitor with the highest voltage resulting in that capacitor discharging more rapidly than the other. The result would be to improve the voltage balance between the clamp capacitors, rather than exacerbate the difference was described above where a contrast power load is applied to the clamp capacitor.

There are various ways in which the power draw from the clamp capacitor can be controlled to provide the general properties of the resistive load.

In one embodiment the power demand from the floating power supply is varied based on an indication of the voltage level of the clamp capacitor. In one embodiment the voltage of the clamp capacitor may be determined and compared to at least one threshold level, with the rated power drawn by the floating power supply varies depending on whether the voltage of the clamp capacitor is above or below the threshold(s).

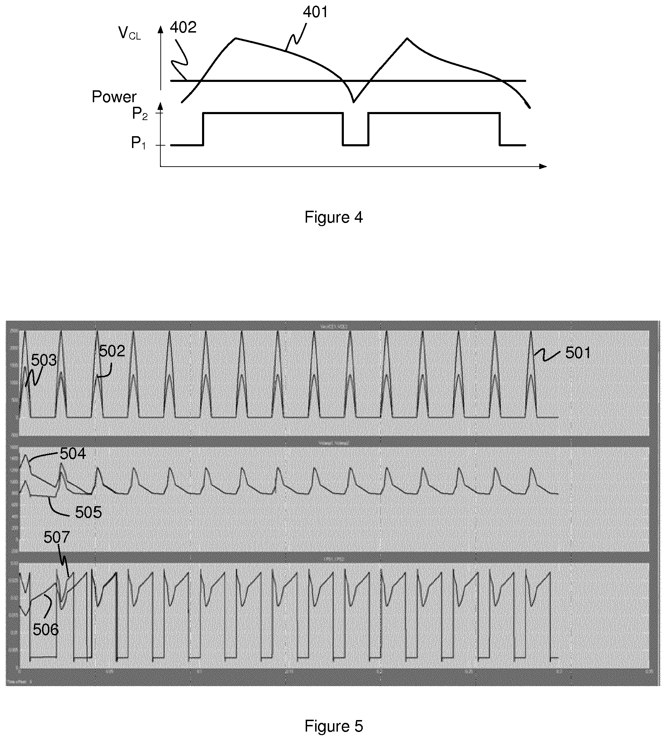

Figure 4 illustrates the principle of altering the rated power of the floating power supply in this way. Figure 4 illustrates the instantaneous value of the voltage $V_{CL}$ of a clamp capacitor of a director switching unit and how it varies over the course of the power cycle. This voltage level is compared to a voltage threshold 402. At time when the voltage $V_{CL}$ is below the threshold the floating power supply is configured to have a first rated power demand $P_1$. If however the voltage $V_{CL}$ exceeds the threshold the power rating is increased to a higher rated power $P_2$ so that the floating power supply draws more power. In this example the clamp capacitor voltage $V_{CL}$ exceed threshold for part of the power cycle and thus the rated power demand of the floating power supply varies during the power cycle.

It will be appreciated that the operation of the floating power supply at any given power rating $P_1$ or $P_2$ is as a constant power load. However, because of the change of power rating during the cycle, over the course of a whole cycle the average power demand will follow resistive load profile. Clamp capacitors with a higher voltage level will, over the course of a cycle, draw a higher average power than clamp capacitors with a lower voltage level. In this case, the rated power level P1 may correspond to the usual load of the gate driver and FPS electronics, whereas the higher power demand P2 may be used to charge the Long Term Storage (LTS) capacitor stage, seen in Fig. 2 as 211. It is this change of power rating during the cycle that provides the voltage balancing mode. The power rating of the floating power supply be varied by a controller 212 that changes parameters of the floating power supply based on an indication of the voltage of the clamp capacitor.

This control strategy was applied for a simulated director switch as discussed above in relation to figure 2, i.e. a director switch with first and second director switching units, with the first switching unit having a higher starting instantaneous voltage than the second switching unit. Again the simulation covered several power cycles of the converter arm. The same starting voltage imbalance as figure 2 was simulated, i.e. with the starting voltage of the clamp capacitor of the first switching unit at 1500V with the capacitor of the second switching unit at 500V. In this simulation however the floating power supply was simulated with a power draw that varied between 22W and 2.2W depending on whether the clamp capacitor voltage was above or below a voltage threshold of 800V. The results are illustrated in figure 5.

Again the top plot of figure 5 shows the total voltage 501 across the director switch and the voltages across the first 502 and second 503 director switch units respectively. The middle plot shows the voltages of the first 504 and second 505 clamp capacitors and the lower plot shows the current draw of the floating power supplies of the first 506 and second 507 director switch units. It can be seen that the average current demand of the floating power supply of the first director switching unit is greater over the first power cycle than that off the second director switch unit. This reduces the voltage imbalance of the clamp capacitors and over the course of just two power cycles the voltage imbalance is effectively removed.

Note that as an alternative to changing the power demand level the current level could instead by varied based on the clamp capacitor voltage being compared to one or more threshold levels. It will be appreciated that there may be more than one threshold and more than two different power or current levels.

Additionally or alternatively the power demand of the floating power supply may be varied during the course of a power supply by only charging the long term storage 211 of the floating power supply 208 at a time when the clamp capacitor is effectively itself being charged by the voltage across the relevant director switch unit and thus there is plenty of energy available to sustain charging of the long term storage.

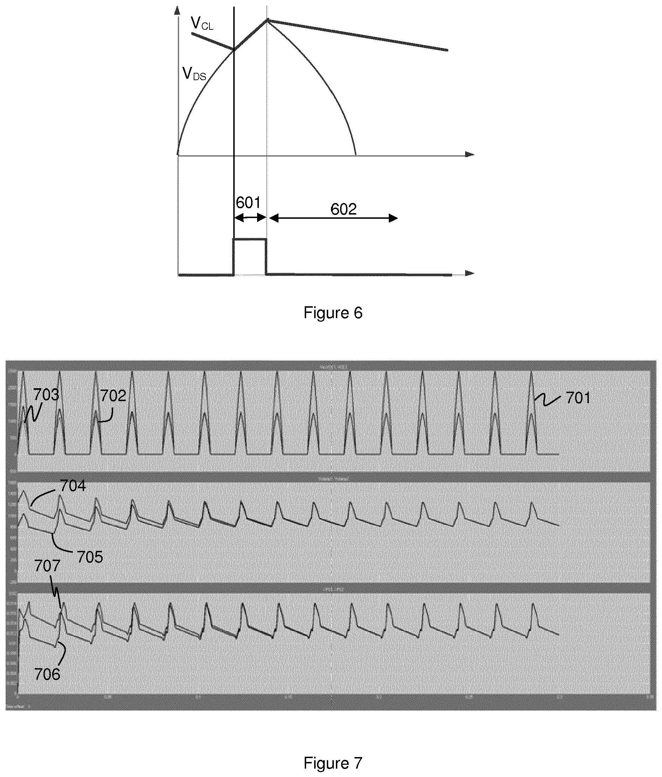

This is illustrated in figure 6. Figure 6 illustrates how the voltage waveform $V_{DS}$ across a director switching unit of the director switch may evolve over time during the period over which the director switch of a converter arm is turned off. For example in an AAC type converter the director switch of the high-side converter arm of a phase limb may be turned off at or before the negative part of the relevant phase cycle. During the period the director switch is off the voltage across the director switch will typically increase to a maximum and then decrease back to zero at which point the director switch is turned on again. The voltage across the director switch will be shared across the director switching units in the off state and across the clamp capacitors. If the voltage across the director switching unit $V_{DS}$ becomes higher than the present voltage of the clamp capacitor, the relevant clamp capacitor will start to be charged. During this period 602 the voltage change of the clamp capacitor, i.e. $dV_{CL}/dt$, will be positive and there will be plenty of energy available for the floating power supply 208 to charge its long term storage without depleting the charge of the clamp capacitor. In some embodiments therefore the floating power supply may be configured so as to charge the long term storage of the floating power supply predominantly at times when the voltage of the clamp capacitor is decreasing. During periods when the voltage of the clamp capacitor is decreasing, i.e. $dV_{CL}/dt$ is negative, then charging of the long term storage of the floating power supply may be suspended.

In another embodiment a resistive load type profile is generated by drawing a current from the clamp capacitor with a component that varies with the voltage of the clamp capacitor. The current may in some embodiments be proportional to the voltage of the clamp capacitor. The current may be drawn inversely proportional to an emulated resistance value, for example a controllable current source may be configured to draw a current that varies in accordance with the clamp capacitor voltage and a virtual resistor value. This value of this virtual resistor $R_{VIRTUAL}$ could for instance be chosen depending on the maximum expected clamp capacitor voltage $V_{CL-MAX}$ and the maximum power rating $P_{MAX}$ of the floating supply. In that way, if the voltage across the clamp capacitor increases, a higher amount of current will be drawn and vice versa. This provides a balancing effect as the clamp capacitor with the higher voltage will be made to provide a higher amount of current than that with a comparatively lower voltage level. The value of the emulated resistor may be such that the resistive load characteristic overcomes that of the constant power load, so that the total net power has a resistive characteristic. The extra power that is drawn can be dumped into a long term storage (LTS) stage such as 211 in Fig. 2.

Thus a current $I_{DEMAND}$ could be drawn according to

$$I_{DEMAND} = V_{CL}/R_{VIRTUAL}$$

where

$$R_{VIRTUAL} = (V_{CL-MAX})^2/P_{MAX}$$

Figure 7 illustrates this control strategy being applied for a simulated director switch as discussed above in relation to figure 2, i.e. a director switch with first and second director switching units, with the first switching unit having a higher starting instantaneous voltage than the second switching unit. Again the simulation covered several power cycles of the converter arm with the same starting conditions.

Again the top plot of figure 7 shows the total voltage 701 across the director switch and the voltages across the first 702 and second 703 director switch units respectively. The middle plot shows the voltages of the first 704 and second 705 clamp capacitors and the lower plot shows the current draw of the floating power supplies of the first 706 and second 707 director switch units. It can be seen that the average current demand of the floating power supply of the first director switching unit is greater over the first power cycle than that off the second director switch unit. This reduces the voltage imbalance of the clamp capacitors and over the course of several power cycles the voltage imbalance is effectively removed.

In some embodiments the current drawn may additionally be based on the rate of change of the clamp capacitor voltage. For instance the current drawn could be reduced when the clamp capacitor is discharging and reduced by a greater amount if the rate of decay of the clamp capacitor voltage is high. Thus, in one embodiment, the current drawn from the clamp capacitor may be

$$I_{DEMAND} = K_1.(V_{CL} / R_{VIRTUAL}) + K_2. (dV_{CL}/dt)$$

where $K_1$ and $K_2$ are weighting factors for weighting the contribution of the resistive and dV/dt characteristics.

In some embodiments a resistive load profile may be achieved by controlling the crowbar circuit so as to provide a desired average resistance value.

As will be understood by one skilled in the art the crowbar circuit is provided to allow for rapid-discharge of the clamp capacitor after an event that produces an overvoltage across the IGBT, typically a hard-switching event. The crowbar circuit has the crowbar resistor 205 in series with a semiconductor switching element, e.g. transistor 207 for activation of the crowbar circuit. The resistance of the crowbar resistor 205 is chosen so as to provide the desired discharge characteristic.

Embodiments of the present invention may operate the crowbar circuit so as to draw a current in a similar fashion as described above. The transistor 207 of the crowbar circuit is controlled so as to enable and disable the current path via the crowbar resistor 205 in a sequence that draws, on average, the required current. In effect the duty cycle of the transistor 207, i.e. the proportion of time that the transistor is conducting compared to the proportion of time that the transistor is non-conducting, is controlled so that the current path via the crowbar resistor has a desired average resistance.

In one embodiment the transistor 207 may be controlled in a pulse-width-modulated (PWM) fashion in a switching cycle with a desired duty cycle. The duty cycle may be controlled to provide a desired average resistance $R_{AV}$ where

$$R_{AV} = R_{CB} / D$$

where $R_{CB}$ is the value of the resistance of the crowbar resistor 205 and D is the duty cycle. The value of the equivalent resistor may be chosen, in a similar fashion as discussed above, so that the equivalent resistor provided by the switched crowbar path draws a maximum rated power $P_{MAX}$ at a maximum expected voltage of the clamp capacitor $Y_{CL\text{-}MAX}$, i.e. such that

$$R_{AV} = (V_{CL\text{-}MAX})^2 / P_{MAX}$$

Thus

$$D = (P_{MAX} \cdot R_{CB})/V_{CL\_MAX}^2$$

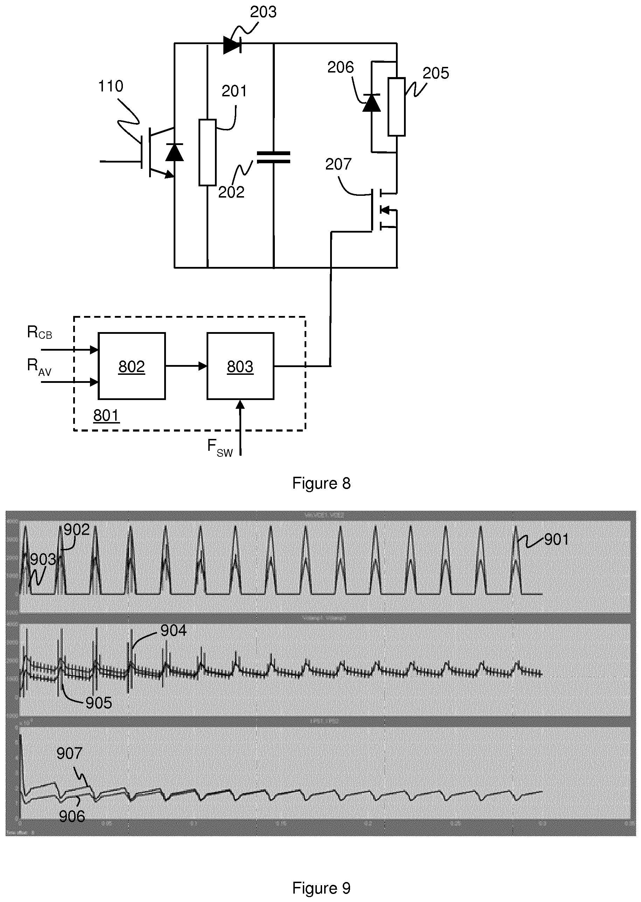

Figure 8 thus illustrates that a controller 801 may be used to control the crowbar transistor 207. The value of the crowbar resistor $R_{CB}$ and the desired average resistance value $R_{AV}$ may be provided to a divider 802 which derives the required duty cycle D, this may be provided to a PWM generator 803 to control switching of the transistor. The PWM generator may for instance comprise a triangle wave generator that generated a repeating ramp waveform based on a switching frequency $F_{SW}$ and a comparator that compared the ramp waveform to a threshold set based on the duty cycle, although many types of PWM generator are known and may be used. The switching frequency Fsw should be high enough that the action of the equivalent crowbar resistance is sufficiently smooth. A switching frequency of the order of a few hundred Hz may be sufficient.

Figure 9 illustrates this control strategy being applied for a simulated director switch as discussed above in relation to figure 2, i.e. a director switch with first and second director switching units, with the first switching unit having a higher starting instantaneous voltage than the second switching unit. Again the simulation covered several power cycles of the converter arm with the same starting conditions. In this case the strategy was employed to provide an emulated resistive load of 22 W at 1250V, using PWM control with a switching frequency of 500 Hz and a crowbar resistor of 2.35 kOhm.

Again the top plot of figure 9 shows the total voltage 901 across the director switch and the voltages across the first 902 and second 903 director switch units respectively. The middle plot shows the voltages of the first 904 and second 905 clamp capacitors and the lower plot shows the current draw of the floating power supplies of the first 906 and second 907 director switch units. The simulated results show similar performance the results of figure 7, with just some increase in switching ripple in the voltages and currents.

It will of course be appreciated that the voltage balancing strategies discussed above, e.g. operation in a voltage balancing mode, may result in additional power being drawn which is in excess of the rated power demand of the gate driver and auxiliary electronic circuitry. In some embodiments any additional power drawn over and above what is needed for the gate driver and auxiliary electronic circuitry 204 may be used to charge the long term storage 211 of the floating power supply. In some embodiments in the event that any charging of the long term storage 211 is required a control of the director switch unit may be configured to adopt one of the strategies described above to charge the long term storage. In this way any voltage imbalance that is present between the director switching units will be reduced or eliminated during the charge up period of the long term storage.

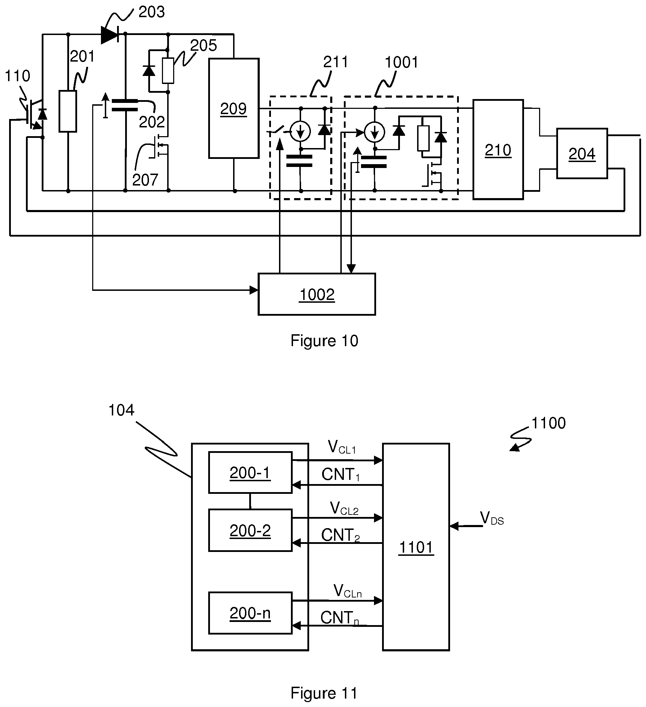

In some embodiments there may further be an additional energy reservoir, e.g. an additional capacitive reservoir. If the long term storage 211 of a power supply of a director switch unit is already fully charged, any additional power drawn by the use of the balancing strategy may be stored in the additional capacitive reservoir. Such an additional capacitive reservoir should have enough capacitance to allow the operation of the balancing strategies for a number of supply cycles. In the event that the additional capacitive balancing reservoir becomes fully charge, it may remain charged, to support any possible loss of supply power. However, if balancing action is required again, it may be rapidly discharged, by dissipating its power through, for instance, a resistive crowbar, before it is used again. Alternatively, the DC-DC converter or the energy storage circuits could be configured so that they have regenerative features. In that case, the stored energy could be returned back into the power system at an appropriate point. Figure 10 illustrates a director switch unit having a floating power supply with long term storage 211 for ensuring a source of power for the gate electronics 204 and also an additional balancing reservoir 1001 with a crowbar circuit so it can be discharged when required. The long term storage and balancing reservoir 1001 may be controlled by a director switch unit controller 1002, which may monitor the voltage of the clamp capacitor 202.

The director switch unit controller of each director switch unit may provide periodic measurements of the voltage of its associated clamp capacitor to a higher level director switch controller. Figure 11 illustrates at least part of a converter arm 1100 having a director switch 104 comprising a plurality of director switch units 200. Each director switch unit may provide periodic measurements of the voltage of the associated clamp capacitor $V_{CL1}$ - $V_{CLn}$ to the director switch controller 1101. Such a director switch controller may determine if there is any voltage imbalance between the clamp capacitors and determine appropriate control signals $CNT_1$ to $CNT_n$ to control the director switch units to operate in a voltage balancing mode. The voltage balancing mode of operation could be applied to all director switch units, or in at least some instance, only to those that are severely unbalanced. Additionally or alternatively, the balancing mode of operation may be activated on a local basis by a switch unit controller 1002, for example if the voltage across the clamp capacitor exceeds a high or low threshold window.

It will be appreciated that in the embodiments described above the input DC/DC converter of the floating power supply is controlled to behave, over the short term, as a constant power load but the operation may be varied over the longer term, e.g. by varying when the DC/DC converter is active or changing the power level, so as to behave as a resistive load over a longer time scale. In some embodiments it would be possible to instead control the DC/DC converter of the floating power supply to behave over the short term as a resistor, that is to draw a current that is proportional to the voltage across its input terminals.

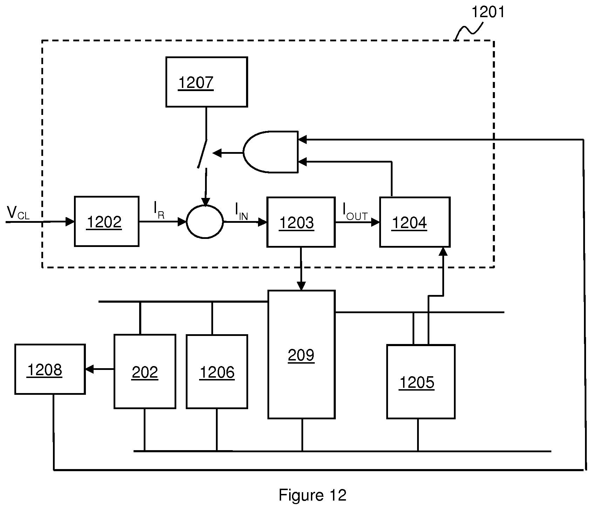

Figure 12 illustrates such an embodiment where the DC/DC converter 209 of the floating power supply is controlled by a controller 1201. The voltage $V_{CL}$ of the clamp capacitor may be supplied to a first control block 1202 that emulates a resistor and determines a suitable current $I_R$ for the DC/DC converter to behave as a restive load. The current may be supplied to a current controller 1203 as an input current $I_{IN}$ for controlling the DC/DC converter 209.

This approach has the drawback that control over the output voltage is lost. However, to overcome that problem, a bulk storage system 1205, for example a comparatively large capacitor, may be connected to the output of the DC-DC converter 209 to keep the output voltage within upper and lower threshold boundaries. To provide the desired control a voltage monitor block 1204 may monitor the voltage of the storage system 1205, and hence the output voltage, against lower and upper thresholds (with hysteresis applied). A further voltage monitor 1208 may be arranged to monitor the voltage of the clamp capacitor 202 with respect to a further threshold level. If the output voltage drops lower than the lower threshold level, voltage monitor 1204 will generate a control signal for charge of the bulk storage capacitor 1205 until the output voltage has reached the upper threshold level. However, that charge will only be enabled if the input clamp capacitor voltage is higher than the further threshold as monitored by block 1208. When both conditions defined by monitoring blocks 1204 and 1208 are simultaneously satisfied, then an extra load current defined by current supply block 1207 will be added to the resistive current demand $I_R$ to be drawn by the DC-DC converter as an input current $I_{IN}$. If the output voltage gets too high, a crowbar circuit 1206 could be activated to discharge it.

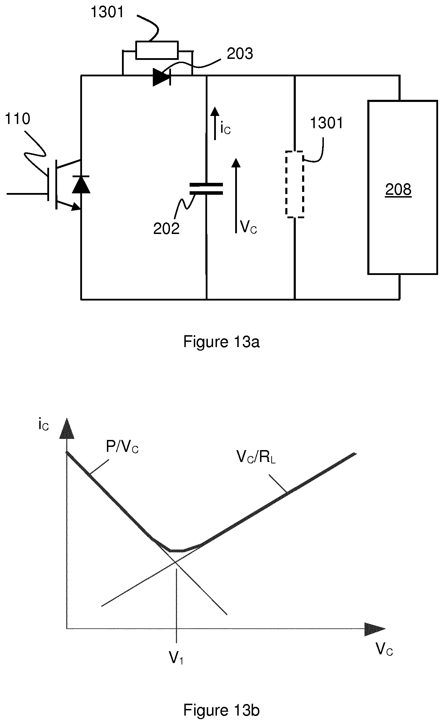

In addition to or instead of controlling the floating power supply to behave as a resistive load in some embodiments the resistive loading of the clamp capacitor could be provided by arranging one or more loading resistors to provide the resistive loading. Such loading resistor(s) could be arranged in one or more different locations, for instance across the clamp diode 203, across the clamp capacitor 202 and/or across the IGBT 110 as illustrated in figure 13a. Figure 13a illustrates a switch unit having a director switch 110 and clamp capacitor 202 and snubber diode 203 as described previously with a floating power supply 208 which, in this example is operated as a constant power load. There is also at least one loading resistor 1301. Figure 1301 shows a loading resistor coupled across, i.e. in parallel with, the snubber diode 203.

In use the clamp capacitor of an individual switch unit will be at a certain voltage level Vc and a certain current ic will be drawn from clamp capacitor 202 according to the power requirements. As shown in figure 13b below a certain

voltage level, $V_1$, of the clamp capacitor the constant power characteristic of the floating power supply will dominate and the current drawn will vary according to the power demand P and the voltage Vc according to the relationship $P/V_C$. However above the voltage level $V_1$ there effect of the loading resistor will start to take over and the current drawn from the clamp capacitor will follow the profile resistive loading, i.e. according to $V_C/R_L$ where $R_L$ represents the effective resistance of the loading resistors.

Embodiments may therefore include one or more loading resistors with appropriate resistance values such that the voltage level $V_1$ at which the resistive characteristics start to dominate is within the normal expected range of voltages of the clamp capacitors 202 of the switching units. In other words the voltage $V_1$ at which the resistive effects start to dominate is lower than a nominal operating voltage for the clamp capacitors 202 of the switch unit.

As mentioned there may be one or more such loading resistors, for instance a loading resistor may additionally or alternatively be arranged in parallel with the clamp capacitor 202 as illustrated in figure 13a.

One skilled in the art will appreciate that the loading resistors would be in addition to or instead of, and will perform a different function to, any resistors typically provided, e.g. resetting the voltage across the clamp capacitor, allowing slow discharge of the clamp capacitor for safety or providing static balancing across the IGBTs. For example as mentioned above some designs of VSC may already include a discharge resistor connected in parallel across the snubber diode 203. This discharge resistor is intended to allow slow discharge of the clamp capacitor voltage after power down of the system and thus has a high resistance value. Likewise a discharge resistor may be connected in parallel with the clamp capacitor to allow for slow discharge following power off of the system. Again this requires a high value of resistance. For such high value resistances the voltage value at which resistive effects would dominate the constant power load characteristics would be well outside the normal operating voltage of the clamp capacitors. Thus during normal, i.e. non-faulted operation within nominal parameters a conventional switching unit would behave according to the constant power loading only and the value of the discharge resistors would not provide operation in a voltage balancing mode. Likewise a balancing resistor may typically be provided across the switching element 110 to ensure correct voltage balancing across the series connected switching elements in the off state, such a resistor may be chosen to have a relatively high value to provide a current which is only slightly higher than the off-state leakage current of the switching elements 110. Again the resistance values of the loading resistors will be significantly different to those of the conventional balancing resistors and thus will provide a different loading response.

The methods and apparatus described above thus achieves the balancing of the clamp capacitors, even under extreme operating conditions, such as a high constant power load being drawn in the presence of significant circuit mismatch. The techniques described herein also allow recovery of the balancing of the clamp capacitors after they have been upset by an external disturbance. Any corrective action is only taken however when the clamp capacitors are imbalanced, returning to an ideal switching pattern afterwards. This provides a very stable operation in normal conditions. The voltage across the various semiconductor switching elements is thus balanced as a consequence of balancing the clamp capacitors.

The various embodiments have been described in respect of an AAC type converter but it will be appreciated that the techniques are applicable to any type of VSC comprising a director switch formed from director switch units having a switching element and a clamp capacitor connected across the switching element where such director switch units also have a floating power supply that draws power from the clamp capacitor.

It should be noted that the above-mentioned embodiments illustrate rather than limit the invention, and that those skilled in the art will be able to design many alternative embodiments without departing from the scope of the appended claims. The word "comprising" does not exclude the presence of elements or steps other than those listed in a claim, "a" or "an" does not exclude a plurality, and a single feature or other unit may fulfil the functions of several units recited in the claims. Any reference signs in the claims shall not be construed so as to limit their scope.

**Claims**

1. A method of controlling a director switch unit (200) of a voltage source converter comprising a semiconductor switching element (110) and an associated clamp capacitor (202) connected across the semiconductor switching element (110), the method comprising, in a voltage balancing mode:

   operating the director switch unit (200) in a voltage balancing mode such that power drawn from the clamp capacitor (202) varies based on the voltage across the clamp capacitor (202),
   **characterised in that** the method comprises, in the voltage balancing mode, varying the power demand or the current demand of a power supply (208) that draws power from the clamp capacitor (202) based on the voltage of the clamp capacitor (202).

2. A method as claimed as in claim 1, wherein in the voltage balancing mode, the power demand for power drawn from the clamp capacitor (202) has the characteristic of a resistive load.

3.  A method as claimed in claim 1 comprising comparing the clamp capacitor voltage to at least one voltage threshold (402) and determining a power demand based on said comparison, wherein the power demand has a first value if the clamp capacitor voltage ($V_{CL}$) is below a first threshold and the power demand has a second higher value if the clamp capacitor voltage ($V_{CL}$) is above the first threshold.

4.  A method as claimed in claim 1 or claim 2, wherein the method comprises, in the voltage balancing mode, varying the current demand from the clamp capacitor (202) based on the voltage of the clamp capacitor (202).

5.  A method as claimed in claim 4, wherein the current demand has a component proportional to the voltage of the clamp capacitor (202) and/or a component inversely proportional to a virtual resistance value ($R_{VIRTUAL}$).

6.  A method as claimed in claim 5, wherein the virtual resistance value is selected to give a predetermined rated power at a maximum expected clamp capacitor voltage ($V_{CL-MAX}$).

7.  A method as claimed in claim 5 or 6, wherein the current demand further has a component that varies based on an indication of the rate of change of the clamp capacitor voltage.

8.  A method as claimed in any of claims 4 to 7, wherein the current demand is controlled by controlling a controllable current source.

9.  A method as claimed in claim 1 or claim 2, wherein the method comprises, in the voltage balancing mode, controlling a crowbar circuit (205,206,207) connected in parallel with the clamp capacitor (202) so as to provide a predetermined average resistance value, wherein the crowbar circuit comprises a crowbar resistor (205) in series with a semiconductor switching element (207).

10. A method as claimed in any preceding claim, wherein any additional power drawn which is in excess of the rated power demand of a power supply of the director switch unit (200) is stored in an energy storage reservoir (211) of the power supply (208).

11. A method as claimed in claim 10, wherein the power supply (208) further comprises a balancing reservoir for storing power drawn in the voltage balancing mode.

12. A method as claimed in claim 1 or claim 2, wherein the director switch unit comprises at least one loading resistor, the loading resistor having a resistance value such that, in use at a clamp capacitor voltage within the nominal operating range of the director switch unit (200), the current drawn from the clamp capacitor (202) increases with clamp capacitor voltage.

13. A method as claimed in claim 12, wherein the at least one loading resistor comprises a loading resistor in parallel with a snubber diode (203) and/or a loading resistor in parallel with the clamp capacitor (202).

14. A director switch unit (200) of a voltage source converter (VSC) comprising:

    a semiconductor switching element (110); and
    a clamp capacitor (202) connected across the semiconductor switching element (110),
    the director switch unit (200) being operable in a voltage balancing mode such that power drawn from the clamp capacitor (202) varies based on the voltage across the clamp capacitor (202),

    **characterised in that** the director switch unit (200) is, in a voltage balancing mode, controllable to varying the power demand or the current demand of a power supply (208) that draws power from the clamp capacitor (202) based on the voltage of the clamp capacitor (202).


**Patentansprüche**

1.  Verfahren zum Steuern einer Wellenleiterschalteinheit (200) eines Spannungsquellenwandlers, der ein Halbleiterschaltelement (110) umfasst und einen zugeordneten Klemmenkondensator (202), der über das Halbleiterschaltelement (110) verbunden ist, wobei das Verfahren umfasst, in einem Spannungsausgleichsmodus:

Betreiben der Wellenleiterschalteinheit (200) in einem Spannungsausgleichsmodus, sodass Leistung, die aus dem Klemmkondensator (202) bezogen wird, basierend auf der Spannung über den Klemmkondensator (202) variiert,
**dadurch gekennzeichnet, dass** das Verfahren, in dem Spannungsausgleichsmodus, Variieren des Leistungsbedarfs oder des Strombedarfs einer Leistungsversorgung (208), die Leistung aus dem Klemmkondensator (202) bezieht, basierend auf der Spannung des Klemmkondensators (202) umfasst.

2. Verfahren nach Anspruch 1, wobei in dem Spannungsausgleichsmodus, der Leistungsbedarf für Leistung, die aus dem Klemmkondensator (202) bezogen wird, die Eigenschaft einer ohmschen Last aufweist.

3. Verfahren nach Anspruch 1, Vergleichen der Klemmkondensatorspannung mit mindestens einem Spannungsschwellenwert (402) umfassend und Bestimmen eines Leistungsbedarfs basierend auf dem Vergleich, wobei der Leistungsbedarf einen ersten Wert aufweist, wenn die Klemmkondensatorspannung ($V_{CL}$) unter einem ersten Schwellenwert liegt und der Leistungsbedarf einen zweiten, höheren Wert aufweist, wenn die Klemmkondensatorspannung ($V_{CL}$) über dem ersten Schwellenwert liegt.

4. Verfahren nach Anspruch 1 oder Anspruch 2, wobei das Verfahren umfasst, in dem Spannungsausgleichsmodus, Variieren des Strombedarfs aus dem Klemmkondensator (202) basierend auf der Spannung des Klemmkondensators (202).

5. Verfahren nach Anspruch 4, wobei der Strombedarf eine Komponente proportional zu der Spannung des Klemmkondensators (202) aufweist und/oder eine Komponente, die invers proportional zu einem virtuellen Widerstandswert ($R_{VIRTUAL}$) ist.

6. Verfahren nach Anspruch 5, wobei der virtuelle Widerstandswert ausgewählt wird, um eine vorbestimmte Nennleistung mit einer maximalen erwarteten Klemmkondensatorspannung ($V_{CL-MAX}$) zu ergeben.

7. Verfahren nach Anspruch 5 oder 6, wobei der Strombedarf weiter eine Komponente aufweist, die basierend auf einer Angabe der Änderungsrate der Klemmkondensatorspannung variiert.

8. Verfahren nach einem der Ansprüche 4 bis 7, wobei der Strombedarf durch Steuern einer steuerbaren Stromquelle gesteuert wird.

9. Verfahren nach Anspruch 1 oder Anspruch 2, wobei das Verfahren, in dem Spannungsausgleichsmodus, Steuern einer Schnellschlussschaltung (205,206,207), die parallel mit dem Klemmkondensator (202) verbunden ist, um einen vorbestimmten durchschnittlichen Widerstandswert bereitzustellen, umfasst, wobei die Schnellschlussschaltung einen Schnellschlusswiderstand (205) in Reihe mit einem Halbleiterschaltelement (207) umfasst.

10. Verfahren nach einem der vorstehenden Ansprüche, wobei jedwede zusätzliche Leistung, die bezogen wird, die den Nennleistungsbedarf einer Leistungsversorgung der Wellenleiterschalteinheit (200) übersteigt, in einem Energiespeicher (211) der Leistungsversorgung (208) gespeichert wird.

11. Verfahren nach Anspruch 10, wobei die Leistungsversorgung (208) weiter einen Ausgleichsspeicher zum Speichern bezogener Leistung in dem Spannungsausgleichsmodus umfasst.

12. Verfahren nach Anspruch 1 oder Anspruch 2, wobei die Wellenleiterschalteinheit mindestens einen Belastungswiderstand umfasst, wobei der Belastungswiderstand einen Widerstandswert aufweist, sodass, bei Verwendung an einer Klemmkondensatorspannung innerhalb des normalen Arbeitsbereichs der Wellenleiterschalteinheit (200), der von dem Klemmkondensator (202) bezogene Strom mit Klemmkondensatorspannung steigt.

13. Verfahren nach Anspruch 12, wobei der mindestens eine Belastungswiderstand einen Belastungswiderstand parallel mit einer Dämpfungsdiode (203) umfasst und/oder einen Belastungswiderstand parallel mit dem Klemmkondensator (202).

14. Wellenleiterschalteinheit (200) eines Spannungsquellenwandlers (VSC), umfassend:

ein Halbleiterschaltelement (110); und

einen Klemmkondensator (202), der über das Halbleiterschaltelement (110) verbunden ist,

wobei die Wellenleiterschalteinheit (200) in einem Spannungsausgleichsmodus betreibbar ist, sodass Leistung, die aus dem Klemmkondensator (202) bezogen wird, basierend auf der Spannung über den Klemmkondensator (202) variiert,

**dadurch gekennzeichnet, dass** die Wellenleiterschalteinheit (200), in einem Spannungsausgleichsmodus, steuerbar ist, den Leistungsbedarf oder den Strombedarf einer Leistungsversorgung (208), die Leistung aus dem Klemmkondensator (202) bezieht, basierend auf der Spannung des Klemmkondensators (202) zu variieren.

## Revendications

1.  Procédé de commande d'une unité commutateur directeur (200) d'un convertisseur de source de tension comprenant un élément de commutation à semi-conducteur (110) et un condensateur de calage (202) associé connecté sur toute l'étendue de l'élément de commutation à semi-conducteur (110), le procédé comprenant, dans un mode équilibrage de tension :

    l'actionnement de l'unité commutateur directeur (200) dans un mode équilibrage de tension de telle sorte que la puissance tirée du condensateur de calage (202) varie en fonction de la tension sur toute l'étendue du condensateur de calage (202),
    **caractérisé en ce que** le procédé comprend, dans le mode équilibrage de tension, la modification de la demande en puissance ou de la demande en courant d'une alimentation électrique (208) qui tire la puissance du condensateur de calage (202) en fonction de la tension du condensateur de calage (202).

2.  Procédé selon la revendication 1, dans lequel dans le mode équilibrage de tension, la demande en puissance pour la puissance tirée du condensateur de calage (202) a la caractéristique d'une charge résistive.

3.  Procédé selon la revendication 1 comprenant la comparaison de la tension de condensateur de calage à au moins une tension seuil (402) et la détermination d'une demande en puissance en fonction de ladite comparaison, dans lequel la demande en puissance a une première valeur si la tension de condensateur de calage ($V_{CL}$) est inférieure à un premier seuil et la demande en puissance a une deuxième valeur plus élevée si la tension de condensateur de calage ($V_{CL}$) est supérieure au premier seuil.

4.  Procédé selon la revendication 1 ou la revendication 2, dans lequel le procédé comprend, dans le mode équilibrage de tension, la modification de la demande en puissance provenant du condensateur de calage (202) sur la base de la tension du condensateur de calage (202).

5.  Procédé selon la revendication 4, dans lequel la demande en courant a une composante proportionnelle à la tension du condensateur de calage (202) et/ou une composante inversement proportionnelle à une valeur de résistance virtuelle ($R_{VIRTUAL}$).

6.  Procédé selon la revendication 5, dans lequel la valeur de résistance virtuelle est choisie pour donner une puissance nominale prédéterminée à une tension de condensateur de calage attendue maximale ($V_{CL-MAX}$).

7.  Procédé selon la revendication 5 ou 6, dans lequel la demande en courant a en outre une composante qui varie sur la base d'une indication de la vitesse de changement de la tension de condensateur de calage.

8.  Procédé selon l'une quelconque des revendications 4 à 7, dans lequel la demande en courant est commandée par commande d'une source de courant pouvant être commandée.

9.  Procédé selon la revendication 1 ou la revendication 2, dans lequel le procédé comprend, dans le mode équilibrage de tension, la commande d'un circuit de limitation en tension (205, 206, 207) connecté en parallèle au condensateur de calage (202) de manière à fournir une valeur de résistance moyenne prédéterminée, dans lequel le circuit de limitation en tension comprend une résistance de limitation en tension (205) en série avec un élément de commutation à semi-conducteur (207).

10.  Procédé selon l'une quelconque des revendications précédentes, dans lequel toute puissance additionnelle tirée qui est supérieure à la demande en puissance nominale d'une alimentation électrique de l'unité commutateur directeur (200) est stockée dans un réservoir de stockage d'énergie (211) de l'alimentation électrique (208.)

11. Procédé selon la revendication 10, dans lequel l'alimentation électrique (208) comprend en outre un réservoir d'équilibrage destiné à stocker la puissance tirée dans le mode équilibrage de tension.

12. Procédé selon la revendication 1 ou la revendication 2, dans lequel l'unité commutateur directeur comprend au moins un rhéostat d'absorption, le rhéostat d'absorption ayant une valeur de résistance telle que, lors d'une utilisation à une tension de condensateur de calage dans la plage de fonctionnement nominal de l'unité commutateur directeur (200), le courant tiré du condensateur de calage (202) augmente avec la tension de condensateur de calage.

13. Procédé selon la revendication 12, dans lequel l'au moins un rhéostat d'absorption comprend un rhéostat d'absorption en parallèle avec une diode de protection (203) et/ou un rhéostat d'absorption en parallèle avec le condensateur de calage (202).

14. Unité commutateur directeur (200) d'un convertisseur de source de tension (VSC) comprenant :

un élément de commutation à semi-conducteur (110) ; et
un condensateur de calage (202) connecté sur toute l'étendue de l'élément de commutation à semi-conducteur (110),
l'unité commutateur directeur (200) pouvant fonctionner dans un mode équilibrage de tension de telle sorte que la puissance tirée du condensateur de calage (202) varie en fonction de la tension sur toute l'étendue du condensateur de calage (202),
**caractérisée en ce que** l'unité commutateur directeur (200) peut, dans un mode équilibrage de tension, être commandée pour modifier la demande en puissance ou la demande en courant d'une alimentation électrique (208) qui tire de la puissance du condensateur de calage (202) en fonction de la tension du condensateur de calage (202).

Figure 1

Figure 2

Figure 3

Figure 4

Figure 5

Figure 6

Figure 7

Figure 8

Figure 9

Figure 10

Figure 11

Figure 12

1301

203

110

1301

208

i_C

202

V_C

Figure 13a

i_C

P/V_C

V_C/R_L

V_1

V_C

Figure 13b

**EP 3 285 380 B1**

**REFERENCES CITED IN THE DESCRIPTION**

**Patent documents cited in the description**

- US 20130082762 A1
- US 201002655740 A1
- WO 2010149200 A